# FASCICULE DE BREVET EUROPEEN

(11) **EP 2 308 797 B1**
(45) Date de publication et mention de la délivrance du brevet: **20.06.2012**
(21) Numéro de dépôt: 10186355.3
(22) Date de dépôt: 04.10.2010
(51) Int. Cl.: B81B 7/00, H01L 23/26

(54) **Structure à cavité comportant une interface de collage à base de matériau getter**
Struktur mit Hohlraum, die eine Bindungsschnittstelle auf der Basis eines Getter-Materials umfasst
Structure with a cavity comprising a bonding interface made from a getter material

(30) Priorité: 07.10.2009 FR 0956999
(43) Date de publication de la demande: 13.04.2011
(73) Titulaire: Commissariat à l'Énergie Atomique et aux Énergies Alternatives, 75015 Paris (FR)
(72) Inventeur: Baillin, Xavier, 38920, Crolles (FR)
(74) Mandataire: Ilgart, Jean-Christophe

(56) Documents cités:
- EP-A2- 1 640 327
- EP-A2- 2 008 966
- US-A- 4 769 345
- US-A1- 2009 155 499
- US-B2- 6 548 889

## Description

### DOMAINE TECHNIQUE

L'invention concerne une structure comportant une cavité, par exemple fermée hermétiquement, dans laquelle est disposé un matériau getter permettant de contrôler l'atmosphère régnant dans la cavité, le matériau getter servant également à réaliser une interface de collage entre les éléments formant la cavité. La structure selon l'invention peut notamment être une structure d'encapsulation d'un dispositif microélectronique et/ou nanoélectronique. L'invention concerne également un procédé de réalisation d'une telle structure.

### ÉTAT DE LA TECHNIQUE ANTÉRIEURE

Certains dispositifs microélectroniques et/ou nanoélectroniques tels que ceux de type MEMS (microsystème électromécanique), NEMS (nanosystème électromécanique), MOEMS (microsystème opto-électromécanique), NOEMS (nanosystème opto-électromécanique) ou encore des détecteurs infrarouges, nécessitent pour leur bon fonctionnement d'être enfermés dans une cavité dont l'atmosphère (nature du gaz, pression) est contrôlée. Ces dispositifs sont généralement réalisés collectivement sur un même substrat (wafer) par exemple à base de silicium, puis encapsulés individuellement dans des cavités hermétiques réalisées par report de capots, généralement en silicium, sur le substrat, puis par scellement hermétique des capots avec le substrat. Les techniques de scellement hermétique connues à ce jour sont : le scellement anodique entre un substrat en verre et un capot en silicium, le scellement eutectique métallique, le scellement direct entre deux éléments de silicium, et la thermocompression entre deux éléments métalliques.

L'ajout d'un getter en couche mince dans la cavité permet de contrôler notamment la pression régnant dans la cavité. Il est connu de déposer un matériau getter en couche mince à l'intérieur de la cavité, soit à coté du dispositif, soit contre le capot de la cavité comme cela est décrit dans les documents US 6 897 551 B2 et WO 2009/087284 A1. Un matériau getter est un matériau comportant, de façon intrinsèque et/ou de par sa morphologie microscopique ou nanoscopique, des propriétés absorbantes et/ou adsorbantes vis-à-vis de molécules gazeuses, pouvant ainsi réaliser une pompe de gaz chimique lorsque celui-ci est disposé dans un environnement clos. Un tel matériau getter permet donc de contrôler la pression dans la cavité dans laquelle est encapsulé un dispositif microélectronique et/ou nanoélectronique. Des matériaux getter non évaporables sont par exemple des métaux tels que du titane, du zirconium, de l'hafnium, ou encore des alliages métalliques de ces métaux ou de d'autres métaux adaptés.

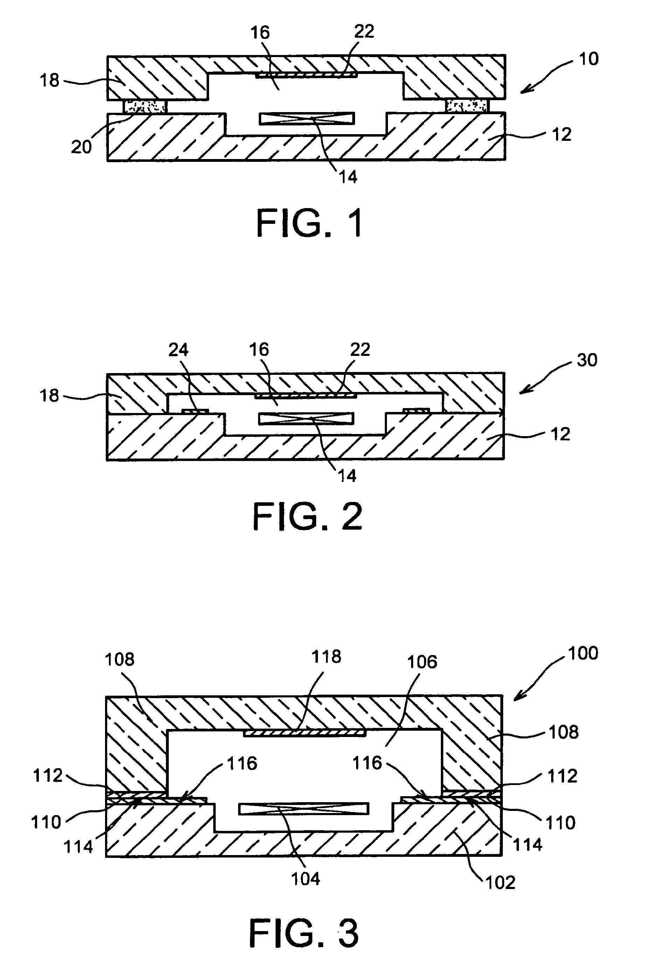

La figure 1 représente un premier exemple d'une structure d'encapsulation 10 comportant un substrat 12 dans lequel est réalisé un dispositif 14. Le dispositif 14 est encapsulé dans une cavité 16 formée entre le substrat 12 et un capot 18 qui sont scellés l'un à l'autre par un cordon de scellement 20. Un matériau getter 22 déposé contre le capot 18 est également disposé dans la cavité 16.

La structure d'encapsulation 10 présente deux inconvénients majeurs :
- le contrôle de l'herméticité du cordon de scellement 20 après sa fusion qui est difficile à obtenir,
- les dimensions du cordon de scellement 20 qui sont difficilement contrôlables car ce cordon risque de s'étaler lors de l'étape de fusion, pouvant provoquer un disfonctionnement du dispositif encapsulé (masse mobile affectée, court-circuit, etc.).

La figure 2 représente un second exemple d'une structure d'encapsulation 30 comportant le dispositif 14 encapsulé dans la cavité 16 formée entre le substrat 12 et le capot 18. A la différence de la structure d'encapsulation 10 représentée sur la figure 1 dans laquelle le capot 18 est solidarisé au substrat 12 par l'intermédiaire du cordon de scellement 20, le capot 18 et le substrat 12 de la structure d'encapsulation 30, qui sont à base de silicium, sont scellés directement l'un à l'autre. En plus du matériau getter 22 déposé contre le capot 18, la structure d'encapsulation comporte également, dans la cavité 16, des portions 24 de matériau getter déposées contre le substrat 12.

La structure d'encapsulation 30, qui comporte un assemblage direct entre deux éléments à base de silicium, nécessite toutefois des traitements en vue d'améliorer l'adhérence moléculaire à température ambiante avant de consolider l'interface par un traitement thermique. Ces traitements, réalisés par voies sèche et/ou humide, sont peu compatibles avec la présence d'un getter dont ils risquent de réduire significativement la capacité de pompage et donc de limiter la pression minimale accessible par ce type de structure.

Les documents EP 2 008 966 A2, US 6 548 889 B2 et EP 1 640 327 A2 décrivent des structures comportant une cavité délimitée par un premier substrat et un seconde substrat solidarisés l'un à l'autre par l'intermédiaire d'une interface de collage, et dans laquelle est disposé un matériau getter faisant également partie de l'interface de collage.

### EXPOSÉ DE L'INVENTION

Un but de la présente invention est de proposer une nouvelle structure, par exemple destinée à encapsuler un dispositif, permettant de garantir une forte herméticité au sein d'une cavité formée dans la structure.

La présente invention propose une structure comportant au moins une cavité délimitée par au moins un premier substrat et au moins un second substrat solidarisé au premier substrat par l'intermédiaire d'au moins une interface de collage, dans laquelle une première partie d'au moins une première portion d'au moins un matériau getter forme une partie de l'interface de collage et une seconde partie de la première portion de matériau getter est disposée dans la cavité, la première portion de matériau getter étant disposée contre le premier substrat ou le second substrat, l'interface de collage comportant en outre au moins une partie d'une seconde portion d'au moins un matériau getter thermocompressée à la première partie de la première portion de matériau getter, ladite seconde portion de matériau getter étant disposée contre le second substrat lorsque la première portion de matériau getter est disposée contre le premier substrat ou disposée contre le premier substrat lorsque la première portion de matériau getter est disposée contre le second substrat.

Ainsi, une même portion de matériau getter permet à la fois de former une partie de l'interface de collage ainsi que de former un getter d'absorption et/ou d'adsorption gazeuse au sein de la cavité. De plus, lorsque cette portion de matériau getter est disposée sur le pourtour de la cavité, une grande surface de getter sera d'autant plus facilement accessible. Par rapport à une structure comportant un cordon de scellement, le dimensionnement de la surface de matériau getter exposée à l'intérieur de la cavité permet de contrôler la pression finale régnant dans la cavité.

Etant donné que les deux portions de matériaux getter formant l'interface de collage sont thermocompressées l'une à l'autre, on a donc une interface de collage formée de matériaux getter ayant subis une interdiffusion l'une avec l'autre.

Il est également proposé une structure comportant au moins une cavité fermée hermétiquement et délimitée par au moins un substrat et au moins un capot solidarisé au substrat par l'intermédiaire d'au moins une interface de collage, dans laquelle au moins une portion d'au moins un matériau getter disposée en partie dans la cavité forme également au moins une partie de l'interface de collage.

Le second substrat peut former un capot.

La cavité peut être fermée hermétiquement.

La première et/ou la seconde portion de matériau getter peut être une couche mince, c'est-à-dire avoir une épaisseur inférieure à environ 2 µm.

L'interface de collage comprend donc une portion de matériau getter en contact avec une autre portion de matériau getter du même type ou différent.

La portion de matériau getter, appelée première portion de matériau getter, est disposée contre le premier substrat ou le second substrat, l'interface de collage comportant en outre au moins une partie d'une seconde portion d'au moins un matériau getter disposé contre au moins une partie de la première portion de matériau getter, ladite seconde portion de matériau getter pouvant être disposée contre le second substrat lorsque la première portion de matériau getter est disposée contre le premier substrat ou disposée contre le premier substrat lorsque la première portion de matériau getter est disposée contre le second substrat.

Le scellement, par exemple hermétique, entre le premier substrat et le second substrat est obtenu via une solidarisation par thermocompression, réalisée entre deux portions de matériaux getter, par exemple métalliques, et peut donc présenter une forte herméticité garantissant un maintien prolongé dans le temps de l'atmosphère obtenue dans la cavité. Ces portions de matériau getter solidarisées l'une à l'autre peuvent être de préférence réalisées toutes les deux en couches minces, par exemple d'une épaisseur comprise entre environ 100 nm et quelques centaines de nanomètres, et présenter une rugosité d'autant plus faible que l'épaisseur et/ou la taille des grains du getter diminuent.

Les matériaux getter de la première et de la seconde portions de matériau getter peuvent avoir des températures d'activation thermique différentes. Dans ce cas, la température d'activation thermique de la première portion de matériau getter peut être inférieure à la température d'activation thermique de la seconde portion de matériau getter. Ainsi, les deux portions de matériau getter, s'activant thermiquement à deux températures différentes, permettront d'atteindre un vide plus poussé dans la cavité de la structure que lorsque ces portions sont à base de matériaux getter dont les températures d'activation thermique sont similaires. En effet, la partie de la première portion de getter située à l'intérieure de la cavité sera alors exposée à un budget thermique supérieur à celui nécessaire pour son activation, ce qui pourra conduire à la saturation de ladite couche et donc obtenir un vide plus poussé que dans le cas opposé.

La structure peut comporter en outre au moins un premier contact électrique disposé contre et/ou dans le premier substrat, et au moins un second contact électrique disposé contre et/ou dans le second substrat, le premier et le second contacts électriques pouvant être reliés électriquement entre eux au moins par l'intermédiaire des parties de la première et de la seconde portions de matériau getter formant l'interface de collage. Ainsi, les portions de matériaux getter formant l'interface de collage forment également une connexion électrique reliant électriquement des contacts électriques formés à travers la structure.

La structure peut comporter en outre un dispositif disposé dans la cavité. Ainsi, la structure forme une structure d'encapsulation de ce dispositif.

La structure peut comporter en outre au moins une autre portion d'au moins un matériau getter disposée dans la cavité, par exemple disposée contre le second substrat. Cette autre portion de matériau getter vient ainsi compléter la première portion de matériau getter formant l'interface de collage et disposée en partie dans la cavité pour réaliser une absorption et/ou une adsorption gazeuse dans la cavité.

La portion de matériau getter peut être disposée contre le premier substrat ou le second substrat par l'intermédiaire d'au moins une première portion d'au moins un matériau, par exemple métallique, apte à modifier la température d'activation thermique de la portion de matériau getter, et/ou, lorsque la structure comporte une seconde portion de matériau getter, la seconde portion de matériau getter peut être disposée respectivement contre le second substrat ou le premier substrat par l'intermédiaire d'au moins une seconde portion d'au moins un matériau, par exemple métallique, apte à modifier la température d'activation thermique de la seconde portion de matériau getter. Ces portions de matériaux d'ajustement de la température d'activation thermique des matériaux getter, qui sont par exemple réalisées à base de cuivre ou d'aluminium, permettent notamment d'abaisser la température d'activation thermique de la ou des portions de matériau getter, limitant ainsi le budget thermique vu par le reste de la structure. De plus, ces portions métalliques d'ajustement de la température d'activation thermique des matériaux getter permettent également d'éliminer les interactions chimiques pouvant intervenir entre le premier substrat, ou le second substrat, et le matériau getter de la première et/ou de la seconde portion de matériau getter. Lorsque des contacts électriques sont formés dans la structure et reliés électriquement entre eux par les portions de matériau getter, on réalisera de préférence des portions électriquement conductrices d'ajustement entre les portions de matériau getter et les contacts électriques.

Ladite partie de la seconde portion de matériau getter peut être collé moléculairement à la première partie de la première portion de matériau getter.

La présente invention concerne également un procédé de réalisation d'une structure comportant au moins les étapes de :
- réalisation d'au moins une première portion d'au moins un matériau getter contre un premier substrat ou un second substrat,
- réalisation d'au moins une seconde portion d'au moins un matériau getter contre le second substrat lorsque la première portion de matériau getter est disposée contre le premier substrat, ou contre le premier substrat lorsque la première portion de matériau getter est disposée contre le second substrat,
- solidarisation du second substrat au premier substrat par thermocompression d'une première partie de la première portion de matériau getter contre au moins une partie de la seconde portion de matériau getter, formant au moins une cavité délimitée par le premier substrat et le second substrat, une seconde partie de la première portion de matériau getter étant disposée dans la cavité.

La mise en oeuvre d'une telle étape de thermocompression pour réaliser la solidarisation des deux substrats présente plusieurs avantages :
- pas de relâchement de gaz dans la cavité par les matériaux getter lors de la solidarisation ;
- bon contrôle dimensionnel de l'interface de collage obtenu car la thermocompression évite un écrasement des matériaux getter, contrairement aux solidarisations impliquant une fonte des matériaux getter.

Le procédé peut comporter en outre, avant l'étape de réalisation de la première portion de matériau getter, une étape de réalisation d'au moins un dispositif dans et/ou contre le premier substrat tel qu'il soit disposé dans la cavité après la solidarisation du second substrat au premier substrat.

La réalisation de la première portion de matériau getter peut comporter au moins une étape de dépôt en couche mince de la première portion de matériau getter contre le premier substrat et/ou le second substrat.

La solidarisation du second substrat au premier substrat comporte la mise en oeuvre d'au moins une étape de thermocompression d'au moins une partie de la première portion de matériau getter contre au moins une partie de la seconde portion de matériau getter.

La solidarisation du second substrat au premier substrat peut comporter la mise en oeuvre d'un collage par adhésion moléculaire de la première partie de la première portion de matériau getter contre ladite partie de la seconde portion de matériau getter.

Dans ce cas, le procédé peut comporter en outre, après la réalisation du collage moléculaire, une étape de consolidation par traitement thermique dudit collage moléculaire, permettant d'améliorer l'adhésion par collage moléculaire sans perturber le matériau getter.

Les dépôts de la première et de la seconde portion de matériau getter peuvent être réalisés de préférence sur une faible épaisseur (par exemple égale à environ 100 nm, ou inférieure à environ 2 µm) par dépôt par PVD (dépôt physique en phase vapeur), par exemple par pulvérisation cathodique ou évaporation, afin que les portions de matériau getter présentent une faible rugosité.

L'étape de réalisation de la première ou de la seconde portion de matériau getter contre le second substrat peut former également au moins une autre portion de matériau getter contre le second substrat telle qu'elle soit disposée dans la cavité après la solidarisation du second substrat au premier substrat.

Le procédé peut comporter en outre avant l'étape de solidarisation du second substrat au premier substrat et après les étapes de réalisation de la première et de la seconde portions de matériau getter, une étape d'oxydation et/ou de nitruration de la première et/ou de la seconde portions de matériau getter pouvant être mise en oeuvre sous atmosphère sèche de dioxygène et/ou de diazote, pouvant former des couches de protection à base d'oxyde et/ou de nitrure de la première et/ou de la seconde portion de matériau getter, lesdites couches de protection pouvant être supprimées lors de la mise en oeuvre de l'étape de solidarisation. Ces couches de protection permettent ainsi d'exposer les portions de matériau getter à l'air ambiant sans que celles-ci soit oxydées ou contaminées par l'air ou la vapeur d'eau présente dans l'air. Lors de l'assemblage réalisé à une température supérieure ou égale à la température d'activation du matériau getter dont la température d'activation est la plus élevée, par exemple comprise entre environ 300°C et 450°C, les portions de matériau getter absorbent ensuite leur couche de protection, supprimant ainsi toute résistance de contact liée à la présence de cette couche de protection à base d'oxyde et/ou de nitrure (particulièrement avantageux lorsque les portions de matériau getter relient électriquement des contacts électriques entre eux). La thermocompression réalisée entre les portions de matériaux getter peut donc se faire lorsque les couches de protection sont éliminées par l'action de la pression appliquée entre les portions de matériau getter ainsi que de la température à laquelle sont soumises les portions de matériau getter.

L'étape d'oxydation et/ou de nitruration peut être mise en oeuvre par exemple juste après le dépôt du getter et dans la même machine de façon à éviter l'exposition du matériau getter à l'air ambiant. Pour un getter déposé par exemple selon un procédé de dépôt par PVD, le traitement peut être réalisé à une pression partielle de gaz (oxygène ou azote) compatible avec la machine de dépôt, soit à une pression supérieure ou égale à environ 10⁻² mbar, ou comprise entre environ 1000 mbar et 10⁻² mbar, et/ou à une température comprise entre environ 50°C et 120°C et/ou pendant une durée comprise entre environ 1 mn et 10 mn. Le paramètre prépondérant pour réaliser cette protection peut être la température, la pression pouvant varier dans une large gamme comprise entre environ 1000 mbar et 10⁻² mbar.

Le procédé peut comporter en outre, entre l'étape d'oxydation et/ou de nitruration et l'étape de solidarisation, la mise en oeuvre d'une étape de traitement thermique, par exemple de désorption, de la première et/ou de la seconde portion de matériau getter à une température inférieure d'environ 50°C à 150°C par rapport à la température d'activation de la portion de matériau getter dont la température d'activation est la plus basse, et sous vide secondaire.

La première et la seconde portions de matériau getter peuvent être réalisées respectivement contre au moins un premier et un second contacts électriques, l'un des premier et second contacts électriques pouvant être disposé contre et/ou dans le premier substrat et l'autre des premier et second contacts électriques pouvant être disposé contre et/ou dans le second substrat, et dans lequel l'étape de solidarisation peut relier électriquement les premier et second contacts électriques entre eux par l'intermédiaire de la première et de la seconde portions de matériau getter.

Le procédé peut comporter en outre, avant l'étape de réalisation de la première portion de matériau getter, une étape de réalisation d'au moins une première portion d'au moins un matériau, par exemple métallique, apte à modifier la température d'activation thermique de la première portion de matériau getter, contre le premier substrat ou le second substrat, la première portion de matériau getter pouvant être réalisée au moins sur la première portion dudit matériau, et/ou, ledit procédé peut comporter en outre, avant l'étape de réalisation de la seconde portion de matériau getter, une étape de réalisation d'au moins une seconde portion d'au moins un matériau, par exemple métallique, apte à modifier la température d'activation thermique de la seconde portion de matériau getter, respectivement contre le second substrat ou le premier substrat, la seconde portion de matériau getter pouvant être réalisée au moins sur la seconde portion métallique. Il pourra être avantageux, pour réaliser ce ou ces portions de matériaux d'ajustement de la température d'activation, d'utiliser un matériau ductile et/ou à faible module d'Young de façon à profiter de sa souplesse qui pourra éventuellement réduire la rugosité du matériau getter et/ou accommoder les contraintes mécaniques résiduelles provoquées par l'assemblage en température.

Le procédé peut comporter en outre, après la solidarisation du second substrat au premier substrat, une ou plusieurs étapes d'activation thermique du ou des matériaux getter disposés dans la cavité.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 et 2 représentent des structures d'encapsulation de dispositifs de l'art antérieur,
- les figures 3 et 4 représentent des structures, par exemple destinées à former des structures d'encapsulation de dispositifs, objets de la présente invention, respectivement selon un premier et un second mode de réalisation,
- les figures 5A et 5B représentent des étapes d'un procédé de réalisation d'une structure, également objet de la présente invention, selon un mode de réalisation particulier,
- la figure 6 représente une structure, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

On se réfère tout d'abord à la figure 3 qui représente une structure 100, servant ici de structure d'encapsulation d'un dispositif 104, selon un premier mode de réalisation.

La structure 100 comporte un premier substrat 102, par exemple à base de semi-conducteur tel que du silicium, sur lequel est réalisé le dispositif microélectronique et/ou nanoélectronique 104, par exemple de type MEMS, NEMS, MOEMS, NOEMS, ou un détecteur infrarouge, par exemple de type microbolomètre. Le dispositif 104 est encapsulé dans une cavité 106 formée entre le substrat 102 et un second substrat 108, également à base de semi-conducteur tel que du silicium, formant ici un capot. La solidarisation entre le second substrat 108 et le premier substrat 102 est réalisée par l'intermédiaire d'une partie 114 d'une première portion de matériau getter 110 déposée sur le premier substrat 102, tout autour du dispositif 104, et d'une seconde portion de matériau getter 112 déposée contre le second substrat 108.

Les première et seconde portions de matériau getter 110 et 112 ont par exemple une épaisseur comprise entre environ 100 nm et 2 µm et sont à base d'un ou plusieurs matériaux métalliques, par exemple du titane et/ou du zirconium et/ou du vanadium et/ou d'un tout autre métal présentant des propriétés d'absorption et/ d'adsorption gazeuse.

L'interface de collage entre le premier substrat 102 et le second substrat 108 est donc formée par ces portions 110, 112 de matériau getter qui ont été thermo-compressées l'une contre l'autre. Les portions 110, 112 de matériau getter sont réalisées ici sous forme de couche mince, ces portions ayant donc une épaisseur inférieure ou égale à environ 2 µm. De plus, ces portions 110 et 112 de matériau getter sont ici déposées par PVD (dépôt physique en phase vapeur), par exemple par pulvérisation cathodique ou par évaporation, ce qui confère à ces portions 110 et 112 une faible rugosité, les rendant ainsi compatibles avec la thermocompression réalisée entre ces portions 110 et 112.

Sur la figure 3, on voit qu'une première partie 114 de la première portion 110 de matériau getter forme, avec la seconde portion 112 de matériau getter, l'interface de collage entre le premier substrat 102 et le second substrat 108, et qu'une seconde partie 116 de la première portion 110, qui est disposée dans la cavité 106, ne forme pas l'interface de collage. Ainsi, la première portion 110 de matériau getter sert donc à la fois à former l'interface de collage entre le premier substrat 102 et le second substrat 108, ainsi que de matériau getter proprement dit, c'est-à-dire à réaliser une absorption et/ou une adsorption gazeuse dans la cavité 106, permettant de contrôler l'atmosphère dans cette cavité 106. Ce rôle d'absorption et/ou d'adsorption gazeuse rempli par la seconde partie 116 de la première portion 110 de matériau getter est également rempli par une portion 118 de matériau getter disposée contre le second substrat 118, dans la cavité 106 et en regard du dispositif 104, le matériau de cette portion 118 étant par exemple le même que celui de la seconde portion 112 de matériau getter.

Il est possible que les matériaux getter des portions 110 et 112 soient de même nature ou non. De plus, il est possible que les matériaux getter des portions 110 et 112 présentent la même température d'activation thermique. Toutefois, on choisit de préférence ces matériaux getter tels que leurs températures d'activation thermique soient différentes. De plus, on choisira de préférence ces matériaux getter tels que le getter comportant la température d'activation thermique est la moins élevée soit le matériau getter de la portion comportant une partie disposée dans la cavité, c'est-à-dire la première portion 110 sur l'exemple de la figure 3, ce qui permettra d'obtenir dans la cavité 106 un vide plus poussé que dans le cas inverse (matériau getter de la portion 110 ayant une température d'activation thermique supérieure à la température d'activation thermique du matériau getter de la portion 112) ou dans le cas où les deux portions 110 et 112 de matériaux getter ont une même température d'activation thermique. La température d'activation thermique des matériaux getter est par exemple égale à environ 450°C lorsque les portions 110 et 112 sont à base de titane.

Dans une variante de réalisation, il est possible que les portions de matériau getter 110 et 112 ne soient pas disposées directement contre le premier substrat 104 et le second substrat 108, mais que des portions métalliques d'ajustement de la température d'activation thermique des matériaux getter soient disposées entre ces portions 110, 112 et le premier substrat 102 et le second substrat 108. Ces portions métalliques, par exemple à base de Cu et/ou de Ni et/ou de Pt et/ou d'Ag et/ou de Ru et/ou de Cr et/ou d'Au et/ou d'Al, permettent de moduler la température à laquelle les portions 110, 112 de matériaux getter réagissent avec l'atmosphère de la cavité 106. Ainsi, il est possible d'abaisser les températures d'activation thermiques des portions 110 et 112 telles qu'elles soient par exemple comprises entre environ 275°C et 425°C en fonction de la nature du métal des portions métalliques d'ajustement et de la nature des matériaux getter.

L'épaisseur de ces portions métalliques est par exemple comprise entre environ 50 nm et 500 nm. Ces portions métalliques d'ajustement peuvent avoir un coefficient de dilatation thermique compris entre environ 5.10⁻⁶/°C et 23.10⁻⁶/°C et un rapport entre leur température d'élaboration (température à laquelle ces portions sont déposées) et leur température de fusion compris sensiblement entre environ 0,1 et 0,3. Les portions métalliques d'ajustement sont par exemple déposées par évaporation. D'autres caractéristiques relatives à ces portions d'ajustement sont décrites dans le document WO 2009/087284.

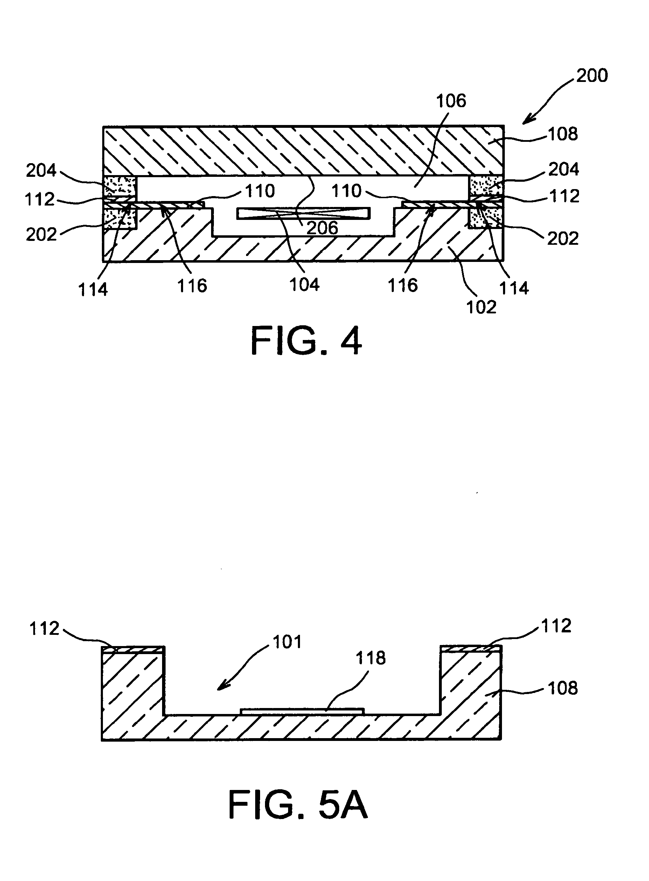

La figure 4 représente une structure 200, formant ici une structure d'encapsulation du dispositif 104, selon un second mode de réalisation. Par rapport à la structure d'encapsulation 100 représentée sur la figure 3, la structure d'encapsulation 200 comporte des contacts électriques 202 formés dans le premier substrat 102 ainsi que des contacts électriques 204 disposés sur une face 206 du second substrat 108 formant une paroi de la cavité 106. Les contacts électriques 202 et 204 sont reliés électriquement entre eux par l'intermédiaire des portions 110 et 112 de matériaux getter qui sont à base de métal. Ainsi, les portions 110 et 112 servent à la fois à réaliser le scellement hermétique entre le second substrat 108 et le premier substrat 102 mais également à relier électriquement entre eux les contacts électriques 110 et 112. De plus, la seconde partie 116 de la première portion 110 de matériau getter sert également, comme dans la structure d'encapsulation 100, à absorber et/ou adsorber les gaz présents dans la cavité 106. Enfin, par rapport à la structure d'encapsulation 100, la structure d'encapsulation 200 ne comporte pas le matériau getter 118.

Dans une variante, il est possible de réaliser, préalablement au scellement entre les portions 110 et 112 de matériaux getter, un traitement des matériaux getter des portions 110 et 112 afin qu'ils soient protégés de l'air ambiant, et notamment de la vapeur d'eau. Pour cela, on injecte du dioxygène sec (O₂) et/ou du diazote sec (N₂) in-situ, c'est-à-dire dans la chambre de dépôt des matériaux getter, à une température comprise entre environ 50°C et 120°C, et par exemple égale à environ 100°C, la pression régnant dans la chambre de dépôt étant par exemple comprise entre environ 1000 mbar et quelques 10⁻³ mbar. En plaçant le matériau getter en présence de dioxygène sec et/ou de diazote sec pendant une durée de quelques minutes, par exemple comprise entre environ 1 mn et 10 mn, on réalise une oxydation et/ou une nitruration par voie sèche des matériaux getter des portions 110 et 112, formant une couche de protection à base d'oxyde et/ou de nitrure en surface des matériaux getter. La couche de protection ainsi formée permet, en cas d'exposition ultérieure du matériau getter à l'air ambiant, de le protéger des altérations chimiques pouvant être causées par les gaz présents notamment dans l'air ambiant car ces gaz sont alors absorbés et/ou adsorbés par la couche de protection sans polluer le matériau getter. Il est donc possible de stocker le premier substrat 102 et le second substrat 108 à l'air ambiant avant de les sceller hermétiquement entre eux. Les autres variantes précédemment décrites en liaison avec le premier mode de réalisation (portions métalliques d'ajustement de la température d'activation thermique des matériaux getter, matériaux getter comportant des températures d'activation thermique différentes ou non) peuvent s'appliquer à ce second mode de réalisation.

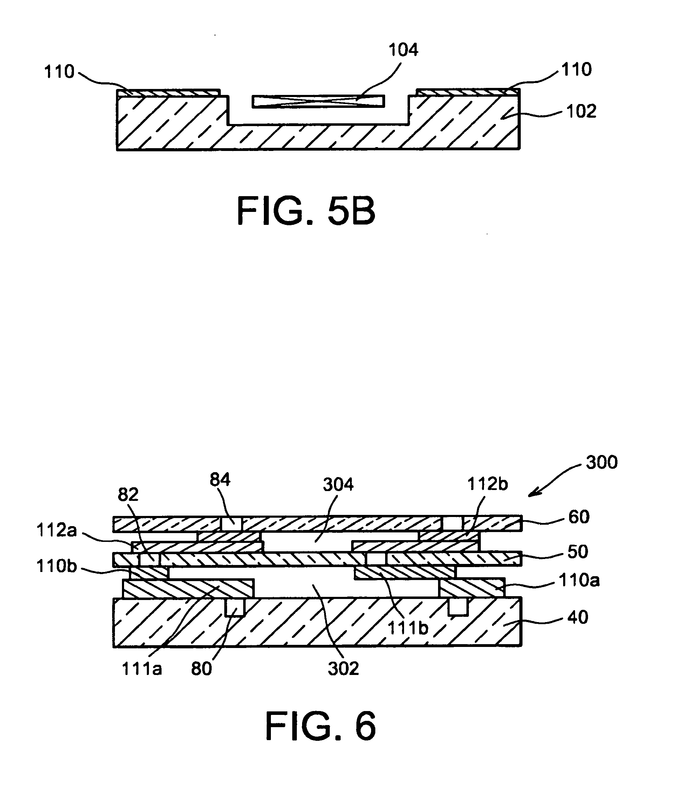

On décrit maintenant en liaison avec les figures 5A et 5B les étapes d'un procédé de réalisation de la structure d'encapsulation 100.

Comme représenté sur la figure 5A, on réalise tout d'abord le second substrat 108 à base de semi-conducteur, par exemple du silicium, dans lequel on réalise un creux 101 qui formera au moins une partie de la cavité 106. Une couche mince de matériau getter est alors déposée sur le second substrat 108 par exemple par un dépôt PVD, puis mise en forme, par exemple par photolithographie et gravure, pour former la seconde portion de matériau getter 112 autour du creux 101 ainsi que la portion 118, disposée dans le creux 101 et destinée à faire face au dispositif 104. Dans une variante de réalisation, notamment lorsque le second substrat présente une topologie importante, la seconde portion 112 ainsi que la portion 118 pourront être réalisées directement par un dépôt lift-off (dépôt à travers un masque sacrificiel réalisé sur le second substrat 108) ou par un dépôt à travers un pochoir.

On réalise ensuite, sur le premier substrat 102 dans lequel le dispositif 104 est réalisé, le dépôt de la première portion 110 de matériau getter, autour du dispositif 104 (figure 5B). Cette première portion 110 de matériau getter pourra être réalisée par la mise en oeuvre de techniques analogues à celles précédemment décrites pour la réalisation de la seconde portion 112 de matériau getter.

Dans une variante, il est possible de réaliser tout d'abord des portions métalliques d'ajustement de la température d'activation thermique sur le premier substrat et/ou le second substrat, par exemple par un dépôt, une photolithographie et une gravure, puis de réaliser sur ces portions métalliques d'ajustement les portions de matériaux getter. Il est aussi avantageux de déposer successivement les portions métalliques et les matériaux getters, puis par photolithographie et gravure de les mettre en forme.

L'assemblage entre le premier substrat 102 et le second substrat 108 est ensuite réalisé par exemple dans une enceinte de scellement permettant de contrôler l'atmosphère à l'intérieur de l'enceinte et d'exercer une pression sur le premier substrat 102 et le second substrat 108 tout en les chauffant, ce qui permet d'obtenir une liaison par diffusion entre les portions 110 et 112 de matériau getter, scellant hermétiquement le second substrat 108 au premier substrat 102. On obtient alors la structure d'encapsulation 100 représentée sur la figure 3, avec la première partie 114 de la première portion 110 de matériau getter thermocompressée contre la seconde portion 112 de matériau getter.

La réalisation de la structure d'encapsulation 200 représentée sur la figure 4 peut comporter la mise en oeuvre d'étapes similaires à celles décrites ci-dessus pour la réalisation de la structure d'encapsulation 100.

Il est possible de solidariser les deux substrats 102 et 108 en réalisant un collage moléculaire entre la première partie 114 de la première portion 110 de matériau getter et la seconde portion 112 de matériau getter.

Lorsqu'une couche de protection à base d'oxyde et/ou de nitrure est réalisée sur les portions 110 et 112 de matériaux getter préalablement à l'assemblage du second substrat 108 au premier substrat 102, et si le premier substrat 102 et/ou le second substrat 108 ont été exposés à l'air ambiant, on réalise, préalablement au scellement hermétique du second substrat 108 au premier substrat 102, un traitement thermique sous vide secondaire, par exemple réalisé à une température égale à environ 150°C, ou plus généralement inférieure d'environ 50°C à 150°C par rapport à la température d'activation du getter dont la température d'activation est la plus basse, pendant une durée comprise entre environ 10 mn et 30 mn, afin de désorber les gaz adsorbés et/ou absorbés par la couche de protection. Ensuite, lors du scellement, les couches de protection disparaissent sous l'effet de la pression exercée entre les portions 110 et 112 et de la température, puis une liaison métal / métal se forme alors par diffusion entre les portions 110 et 112, fermant hermétiquement la cavité 106.

On décrit maintenant, en liaison avec la figure 6, une structure 300 obtenue par l'assemblage en trois dimensions de trois substrats comportant des composants microélectroniques et/ou nanoélectroniques (par exemple du type CMOS, des capteurs, ...) référencés 40, 50 et 60. Chacun des trois substrats 40, 50 et 60 comporte des vias, ou contacts électriques, respectivement référencés 80, 82 et 84 et reliés électriquement entre eux par des couches de matériaux getter 110a, 110b et 112a, 112b servant également à solidariser les substrats 40, 50 et 60 entre eux. Le premier substrat 40 forme ici un socle de la structure 300 et sert également de poignée de la structure 300. Le premier substrat 40 est par exemple un substrat comportant des dispositifs de type CMOS servant par exemple à piloter un ou plusieurs capteurs qui lui sont rapportés, par exemple par les substrats 50 et/ou 60. Les substrats 50 et 60 peuvent par exemple être réduits en épaisseur de façon à pouvoir récupérer plus facilement les contacts électriques traversant. Des cavités 302 et 304 sont formées respectivement entre les substrats 40 et 50 et entre les substrats 50 et 60. De plus, des parties 111a, 111b des couches de matériau getter 110a, 110b sont disposées à l'intérieur de la cavité 302.

Les matériaux getter 110a, 110b, 112a et 112b peuvent être de même nature ou non. Il est par exemple possible que les couches de matériau getter 110a, 110b aient une température d'activation différente de celle des couches de matériau getter 112a, 112b. De plus, afin d'ajuster les scellements réalisés en fonction de la température maximale admissible par les substrats empilés mais également de contrôler la résistance électrique des interconnexions obtenus par scellement, il est possible d'ajouter à la structure 300 une ou plusieurs sous-couches d'ajustement telles que décrites dans le document WO 2009/087284 A1. Par exemple, si le substrat 60 est sensible à la température, on choisit de préférence un getter activable à basse température pour réaliser l'assemblage avec le reste de la structure 300. On peut ainsi imaginer de réaliser une structure comportant une pluralité de substrats reliés électriquement entre eux.

Lorsque la structure 300 comporte une ou plusieurs sous-couches d'ajustement, la structure 300 peut être réalisée à partir de matériaux getter dont la température d'activation décroit au fur et à mesure que l'on s'éloigne du socle (premier substrat 40), protégeant ainsi les composants supérieurs d'une température excessive, ou l'inverse, accroissant ainsi la diffusion dans les getters de plus basse température d'activation, augmentant ainsi la solidité de la liaison métal-métal.

On décrit maintenant un exemple de procédé de réalisation de la structure 300.

On réalise tout d'abord les dépôts des couches de matériau getter 110a, 110b sur les substrats 40 et 50. Les couches de matériau getter 110a, 110b sont alors mises en forme par photolithographie et gravure de chacune de ces couches. Les substrats 40 et 50 sont ensuite solidarisés l'un à l'autre, par exemple par thermocompression des couches de matériau getter 110a, 110b entre elles.

Le substrat 50 est alors aminci et poli à une épaisseur compatible avec une technologie dite de via traversant (« Trough Silicon Via » en anglais, ou TSV) permettant de connecter le via 80 au via 82. Ces étapes sont ensuite répétées afin de solidariser le substrat 60 avec le substrat 50 par l'intermédiaire des couches de matériau getter 112a, 112b, reliant ainsi les vias 80 aux vias 84. Il est ainsi possible d'empiler une pluralité de substrats et obtenir une connexion électrique entre tous les substrats et/ou faire ressortir les contacts électriques de part et d'autre de l'assemblage final.

Par rapport aux structures de l'art antérieur, lors de la réalisation de la structure 300, l'étape de solidarisation peut se faire à l'échelle du wafer, sans faire appel à une brasure ou tout autre procédé nécessitant de passer par une phase liquide. Il est ainsi possible de solidariser une pluralité de substrats sans avoir à se soucier de la fusion des brasures. Dans ce cas, l'augmentation du budget thermique permet de consolider la structure 300.

De plus, le choix des matériaux getter permet d'ajuster la température de solidarisation d'un substrat sur la structure 300 déjà réalisée, mais aussi la conductivité électrique du matériau getter. Enfin, la solidarisation ainsi réalisée, suivie d'une étape d'amincissement et/ou de polissage du dernier substrat, comme par exemple la construction d'un microdispositif.

Il est donc possible de réaliser un empilement en trois dimensions de structures analogues telles que des substrats, et/ou de composants microélectroniques, en vue de réaliser un dispositif présentant une pluralité de fonctions par exemple pour une surface équivalente à celle d'un seul composant.

## Revendications

1. Structure (100, 200, 300) comportant au moins une cavité (106, 302) délimitée par au moins un premier substrat (40, 102 et. au moins an second substrat (50, 108) solidarisé au premier substrat (40, 102.) par l'intermédiaire d'au moins une interface de collage (110, 110b, 112, 114), dans laquelle une première partie (114) d'au moins une première portion (110, 110a) d'au moins un matériau getter forme une partie de l'interface dé collage (110a, 110b, 112, 114) et une seconde partie (116) de la première portion (110, 110a) de matériau getter est disposée dans la cavité (106, 302), la première portion (110, 110a) de matériau getter étant disposée contre le premier substrat (40, 102) ou le second, substrat (50, 108), l'interface de collage (110a, 110b, 112, 114) comportant én outre au moins une partie d'une seconde portion (110b, 112) d'au moins un matériau getter thermocompressée à la première partie (114) de la première portion (110, 110a) de matériau getter, ladite seconde portion (110b, 112) de matériau getter étant disposée contre le second substrat (50, 108) lorsque la première portion (110, 110a) de matériau getter est disposée contre le premier substrat (40, 102) ou disposée contre le premier substrat (40, 102) lorsque la première portion (110, 110a) de matériau getter est disposée contre le second substrat (50, 108).

2. Structure (100, 200) selon la revendication 1, dans laquelle le seconde substrat (108) forme un capot

3. Structure (100, 200) selon l'une des revendications précédentes, dans laquelle la cavité (106) est fermée hermétiquement.

4. Structure (100, 200) selon l'une des revendications précédentes, dans laquelle la première et/ou la seconde portion (110, 112) de matériau getter est une couche mince.

5. Structure (100, 200) selon l'une des revendications précédentes, dans laquelle les matériau getter de la première (110) et de la seconde (112) portions de matériau getter ont des températures d'activation thermique différentes.

6. Structure (100, 20:0) selon la revendication 5, dans laquelle la température d'activation thermique de la première portion (110) de matériau getter est inférieure à la température d'activation thermique de la seconde portion (112) de matériau getter.

7. Structure (200, 300) selon l'une des revendications précédentes, comportant en outre au moins un premier contact électrique (80, 202) disposé contre et/ou dans le premier substrat (40, 102), et au moins un second contact électrique (82, 204) disposé contre et/ou dans le seconde substrat (50, 108), les premier (202) et second (204) contacts électriques étant reliés électriquement entre eux au moins par l'intermédiaire des parties de la première (110, 110a) et de la seconde (112, 110b) portions de matériau getter formant l'interface de collage (110a, 110b, 112, 114).

8. Structure (100, 200) selon l'une des revendications précédentes, comportant en outre un dispositif (104) disposé dans la cavité (106).

9. Structure selon une des revendications précédentes, comportant en outre au moins une autre portion (118) d'au moins un matériau getter disposée dans la cavité (106).

10. structure (100, 200, 300) selon l'une des revendications précédentes, dans laquelle la portion (110, 110a) de matériau getter est disposée contre le premier substrat (40, 102) ou le second substrats (50, 108) par l'intermédiaire d'au moins une première portion d'au moins un matériau apte à modifier la température d'activation thermique de la potion (110, 110a) de matériaux getter, et/ou la seconde portion (110b, 112) de matériaux getter est disposée respectivement contre les seconde substrat (50, 108) ou le premier substrat (40, 102) par l'intermédiaire d'au moins une seconde portion d'au moins un matériau apte à modifier la températures d'activation thermique de la seconde portion (110b, 112) de matériau getter.

11. Structure (100, 200, 300) selon l'une des revendications précédentes, dans laquelle ladite partie de la seconde portion (110b, 112) de matériau getter est collé moléculairement à la première partie (114) de la première portion (110, 110a) de matériau getter.

12. Procédé de réalisation d'une structure, (100, 200, 300) comportant au moins les étapes de :
- réalisation d'au moins une première portion (110, 110a) d'au moins un matériau getter contre un premier substrat (40, 102) ou un second substrat (50, 108),
- réalisation d'au moins une seconde portion (110b, 112) d'au moine un matériau getter contre le seconde substrat (50, 108) lorsque la première portion (110, 110a) de matériau getter est disposée contre le premier substrat (40, 102), ou contre le premier substrat (40, 102) lorsque la première portion (110, 110a) de matériau getter est disposée contre le seconde substrat (50, 108),
- solidarisation du second substrat (50, 108) au premier substrat (40, 102) par thermocompression d'une première, partie (114) de la première portion (110, 110a) de matériau getter contre au moins une partit de la seconde portion (110b, 112) de matériau getter, formant au moins une cavité (106, 302) délimitée par le premier substrat (40, 102) et. le second substrat (50, 108), une seconde partie, (116) de la première portion (110, 110a) de matériau getter étant disposée dans la cavité (106).

13. Procédé selon la revendication 12, comportant en outre, avant l'étape de réalisation de la première portion (110) de matériau getter, une étape de réalisation d'au moins un dispositif (104) dans et/ou contre le premier substrat (102) tel qu'il soit disposée dans la cavité (106) après la solidarisation du second substrat (108) au premier substrat (102).

14. Procédé selon l'une des revendications 12 ou 13, dans lequel la réalisation de la première potion (110) de matériau getter comporte au moins une étape de dépôt en couche mince de la première portions (110) de matériau getter contre le premier substrat (102) ou le second substrat (108).

15. Procédé selon l'une des revendication 12 à 14, dans lequel la solidarisation du seconde substrat (50, 108) au premier substrat (40, 102) comporte la mise en oeuvre d'un collage par adhésion moléculaire de la première partie (114) de la première portion (110, 110a) de matériau getter contre ladite partie de la seconde portion (110b, 112) de matériau getter.

16. Procécé selon la revendication 15, comportant en outre, auprès la réalisation du collage moléculaire, une étape de consolidation par traitement thermique dudit collage moléculaire.

17. Procédé selon l'une des revendications 12 à 16, dans lequel l'étape de réalisation de la première (110) ou de la seconde (112) portion de matériau getter contre le second substrat (108) forme également au moins une autre portion (11-8) de matériau getter contre le second substrat (108) telle qu'elle soit disposée dans la cavité (106) après la solidarisation du second substrat (108) au premier substrat (102).

18. Procédé selon l'une des revendications 12 à 17, comportant en outre avant l'étape de solidarisation du second substrat (108) au premier substrat (102) et après les étapes de réalisation de la première (110) est de la seconde (112) portions de matériau getter, une étape d'oxydation et/ou de nitruration de la première (110) et/ou de la seconde (112) portion de matériau getter mise en oeuvre sous atmosphère sèche de dioxygène et/ou de diazote, formant des couches de protection à base d'oxyde et/ou de nitrure de la première (110) et/ou de la seconde (112) portions de matériau getter, lesdites couches de protection étant supprimées lors de la mise en oeuvre de l'étape de solidarisation.

19. Procédé selon la revendication 18, dans lequel l'étape d'oxydation et/ou de nitruration est mise en oeuvre à une pression comprise entre environ 1000 mbar et 10⁻² mbar et/ou à une température comprise entre environ 50°C et 120°C et/ou pendant une durée comprise entre environ 1 mn et 1.0 mn.

20. Procédé selon l'une des revendications 18 ou 19, comportant en outre, entre l'étape d'oxydation et/ou de nitruration et l'étape de solidarisation, la mise en oeuvre d'une étape de traitement thermique de la première (110) et/ou de la seconde (112) portions de matériau getter à une température inférieure d'environ. 50°C à 150°C par rapport à la température d'activation de la portion de matériau getter dont la température d'activation est la plus basse, et sous vide secondaire.

21. Procédé selon l'une des revendication 12 à 20, dans lequel la première (110, 110a) et la seconde portion (110b, 122) de matériau getter sont réalisées respectivement contre au moins un premier (80, 202) et un second (82, 204) contacts électriques, l'un (80, 202) des premier et second contacts électriques étant disposé contre et/ou dans le premier substrat (40, 102) et l'autre (82, 204) des premier et second contacts électriques étant disposé contre et/ou dans le second substrat (50, 108), et dans lequel l'étape de solidarisation relie électriquement les premier (80, 202) et second (82, 204) contacts électriques entre eux par l'intermédiaire de la première (110, 110a) et de la seconde (110b, 112) portions de matériau getter.

22. Procédé selon l'une de.s revendications 12 à 21, comportant en outre, avant l'étape de réalisation de la première, portion (110) de matériau guetter, une étape, de réalisation d'au moins une première portion d'au moins un matériau apte à modifier la température d'activation thermique de la première portion (110) de matériau getter, contre le premier substrat (102) ou le second substrat (108), la première portion (110) de matériau getter étant réalisée au moins sur la première portion dudit matériau, et/ou ledit procédé comporte en outre, avant l'étape de réalisation de la seconde portion (112) de matériau getter, une étape de réalisation d'au moins une seconde portion d'au moins un matériau apte à modifier la température d'activation thermique de la seconde portion (112) de matériau getter, respectivement contre le second substrat (108) ou le premier substrat (102), la secondé portion (112) de matériau getter étant réalisée au moins sur la seconde portion dudit matériau.

23. Procédé selon l'une des revendications 12 à 22, comportant en outre, après la solidarisation du second substrat (108) au premier substrat (102), une ou plusieurs étapes d'activation thermique du ou des matériaux getter (116, 1.18) disposés dans la cavité (106)

## Claims

1. A structure (100, 200, 300) comprising at least one cavity (106, 302) delimited by at least one first substrate (40, 102) and at least one second substrate (50, 108) attached to the first substrate (40, 102) by means of at least one adhesion interface (110a, 110b, 112, 114), in which a first part (114) of at least one first portion (110, 110a) of at least one getter material forms part of the adhesion interface (110a, 110b, 112, 114) and a second part (116) of the first portion (110, 110a) of getter material is placed in the cavity (106, 302), the first portion (110, 110a) of getter material being placed against the first substrate (40, 102) or the second substrate (50, 108), the adhesion interface (110a, 110b, 112, 114) further comprising at least one part of a second portion (110b, 112) of at least one getter material thermocompressed to the first part (114) of the first portion (110, 110a) of getter material, said second portion (110b, 112) of getter material being placed against the second substrate (50, 108) when the first portion (110, 110a) of getter material is placed against the first substrate (40, 102) or placed against the first substrate (40, 102) when the first portion (110, 110a) of getter material is placed against the second substrate (50, 108).

2. The structure (100, 200) according to claim 1, in which the second substrate (108) forms a cover.

3. The structure (100, 200) according to one of the preceding claims, in which the cavity (106) is hermetically sealed.

4. The structure (100, 200) according to one of the preceding claims, in which the first and/or the second portion (110, 112) of getter material is a thin layer.

5. The structure (100, 200) according to one of the preceding claims, in which the getter materials of the first (110) and of the second (112) portions of getter material have different thermal activation temperatures.

6. The structure (100, 200) according to claim 5, in which the thermal activation temperature of the first portion (110) of getter material is less than the thermal activation temperature of the second portion (112) of getter material.

7. The structure (200, 300) according to one of the preceding claims, further comprising at least one first electrical contact (80, 202) placed against and/or in the first substrate (40, 102), and at least one second electrical contact (82, 204) placed against and/or in the second substrate (50, 108), the first (202) and second (204) electrical contacts being connected together electrically at least by means of the parts of the first (110, 110a) and of the second (112, 110b) portions of getter material forming the adhesion interface (110a, 110b, 112, 114).

8. The structure (100, 200) according to one of the preceding claims, further comprising a device (104) placed in the cavity (106).

9. The structure (100) according to one of the preceding claims, further comprising at least one other portion (118) of at least one getter material placed in the cavity (106).

10. The structure (100, 200, 300) according to one of the preceding claims, in which the portion (110, 110a) of getter material is placed against the first substrate (40, 102) or the second substrate (50, 108) by means of at least one first portion of at least one material suitable for modifying the thermal activation temperature of the portion (110, 110a) of getter material, and/or the second portion (110b, 112) of getter material is placed respectively against the second substrate (50, 108) or the first substate (40, 102) by means of at least one second portion of at least one material suitable for modifying the thermal activation temperature of the second portion (110b, 112) of getter material.

11. The structure (100, 200, 300) according to one of the preceding claims, in which said part of the second portion (110b, 112) of getter material is adhered molecularly to the first part (114) of the first portion (110, 110a) of getter material.

12. A method for making a structure (100, 200, 300) comprising at least the steps of:
- making at least one first portion (110, 110a) of at least one getter material against a first substrate (40, 102) or a second substrate (50, 108),
- making at least one second portion (110b, 112) of at least one getter material against the second substrate (50, 108) when the first portion (110, 110a) of getter material is placed against the first substrate (40, 102), or against the first substrate (40, 102) when the first portion (110, 110a) of getter material is placed against the second substrate (50, 108),
- attaching the second substrate (50, 108) to the first substrate (40, 102) by thermocompression of a first part (114) of the first portion (110, 110a) of getter material against at least one part of the second portion (110b, 112) of getter material, forming at least one cavity (106, 302) delimited by the first substrate (40, 102) and the second substrate (50, 108), a second part (116) of the first portion (110, 110a) of getter material being placed in the cavity (106).

13. The method according to claim 12, further comprising, prior to the step for making the first portion (110) of getter material, a step for making at least one device (104) in and/or against the first substrate (102) such that it is placed in the cavity (106) after attaching the second substrate (108) to the first substrate (102).

14. The method according to one of claims 12 or 13, in which the making of the first portion (110) of getter material comprises at least one step of depositing as a thin layer of the first portion (110) of getter material against the first substrate (102) or the second substrate (108).

15. The method according to one of claims 12 to 14, in which attaching the second substrate (50, 108) to the first substrate (40, 102) comprises using adhesion by molecular adhesion of the first part (114) of the first portion (110, 110a) of getter material against said part of the second portion (110b, 112) of getter material.

16. The method according to claim 15, further comprising, after making the molecular adhesion, a connection step by thermal treatment of said molecular adhesion.

17. The method according to one of claims 12 to 16, in which the step for making the first (110) or the second (112) portion of getter material against the second substrate (108) also forms at least one other portion (118) of getter material against the second substrate (108) such that it is placed in the cavity (106) after attaching the second substrate (108) to the first substrate (102).

18. The method according to one of claims 12 to 17, further comprising prior to the step for attaching the second substrate (108) to the first substrate (102) and after the steps for making the first (110) and of the second (112) portions of getter material, an oxidation and/or nitriding step of the first (110) and/or of the second (112) portions of getter material made under dry atmosphere of dioxygen and/or dinitrogen, forming protective layers composed of oxide and/or nitride of the first (110) and/or of the second (112) portions of getter material, said protective layers being deleted during executing the connection step.

19. The method according to claim 18, in which the oxidation and/or nitriding step is executed at a pressure between approximately 1000 mbar and 10⁻² mbar and/or at a temperature between approximately 50°C and 120°C and/or over a period between approximately 1 min and 10 min.

20. The method according to one of claims 18 or 19, further comprising, between the oxidation and/or nitriding step and the connection step, conducing a step of thermal treatment of the first (110) and/or of the second (112) portions of getter material at a temperature less than approximately 50°C to 150°C relative to the activation temperature of the portion of getter material whereof the activation temperature is the lowest, and under secondary vacuum.

21. The method according to one of claims 12 to 20, in which the first (110, 110a) and the second portion (110b, 112) of getter material are made respectively against at least a first (80, 202) and a second (82, 204) electrical contacts, one (80, 202) of the first and second electrical contacts being placed against and/or in the first substrate (40, 102) and the other (82, 204) of the first and second electrical contacts being placed against and/or in the second substrate (50, 108), and in which the connection step electrically connects together the first (80, 202) and second (82, 204) electrical contacts by means of the first (110, 110a) and of the second (110b, 112) portions of getter material.

22. The method according to one of claims 12 to 21, further comprising, prior to the step for making the first portion (110) of getter material, a step for making at least one first portion of at least one material suitable for modifying the thermal activation temperature of the first portion (110) of getter material, against the first substrate (102) or the second substrate (108), the first portion (110) of getter material being made at least on the first portion of said material, and/or said method further comprises, prior to the step for making the second portion (112) of getter material, a step for making at least one second portion of at least one material suitable for modifying the thermal activation temperature of the second portion (112) of getter material, respectively against the second substrate (108) or the first substrate (102), the second portion (112) of getter material being made at least on the second portion of said material.

23. The method according to one of claims 12 to 22, further comprising, after attaching the second substrate (108) to the first substrate (102), one or more thermal activation steps of the getter material or of the getter materials (116, 118) placed in the cavity (106).

## Patentansprüche

1. Struktur (100, 200, 300), aufweisend mindestens einen Hohlraum (106,3 02), der durch mindestens ein erstes Substrat (40, 102) und mindestens ein zweites Substrat (50, 108) begrenzt ist, das mit dem ersten Substrat (40, 102) mittels mindestens einer Verschweißungskontaktfläche (110a, 110b, 112, 114) fest verbunden ist, bei der ein erster Teil (114) mindestens eines ersten Abschnittes (110, 110a) aus mindestens einem Getter-Material einen Teil der Verschweißungskontaktfläche (110a, 110b, 112, 114) bildet und ein zweiter Teil (116) des ersten Abschnittes (110, 110a) aus Getter-Material in dem Hohlraum (106, 302) angeordnet ist, wobei der erste Abschnitt (110, 110a) aus Getter-Material gegen das erste Substrat (40, 102) oder das zweite Substrat (50, 108) angeordnet ist, wobei die Verschweißungskontaktfläche (110a, 110b, 112, 114) weiter mindestens einen Teil eines zweiten Abschnittes (110b, 112) aus mindestens einem Getter-Material aufweist, das durch Thermokompression mit dem ersten Teil (114) des ersten Abschnittes (110, 110a) aus Getter-Material verbunden ist, wobei der zweite Abschnitt (110b, 112) aus Getter-Material gegen das zweite Substrat (50, 108) angeordnet ist, wenn der erste Abschnitt (110, 110a) aus Getter-Material gegen das erste Substrat (40, 102) angeordnet ist, oder gegen das erste Substrat (40, 102) angeordnet ist, wenn der erste Abschnitt (110, 110a) aus Getter-Material gegen das zweite Substrat (50, 148) angeordnet ist.

2. Struktur (100, 200) nach Anspruch 1, bei der das zweite Substrat (108) eine Kappe bildet.

3. Struktur (100, 200) nach einem der vorhergehenden Ansprüche, bei welcher der Hohlraum (106) hermetisch verschlossen ist.

4. Struktur (100, 200) nach einem der vorhergehenden Ansprüche, bei welcher der erste und/oder der zweite Abschnitt (110, 112) aus Getter-Material eine dünne Schicht ist.

5. Struktur (100, 200) nach einem der vorhergehenden Ansprüche, bei der die Getter-Materialien des ersten (110) und des zweiten (112) Abschnittes aus Getter-Material unterschiedliche thermische Aktivierungstemperaturen haben.

6. Struktur (100, 200) nach Anspruch 5, bei der die thermische Aktivierungstemperatur des ersten Abschnittes (110) aus Getter-Material geringer als die thermische Aktivierungstemperatur des zweiten Abschnittes (112) aus Getter-Material ist.

7. Struktur (200, 300) nach einem der vorhergehenden Ansprüche, weiter aufweisend mindestens einen ersten elektrischen Kontakt (80, 202), der gegen das und/oder in dem ersten Substrat (40, 102) angeordnet ist, und mindestens einen zweiten elektrischen Kontakt (82, 204), der gegen das und/oder in dem zweiten Substrat (50, 108) angeordnet ist, wobei der erste (202) und der zweite (204) elektrische Kontakt miteinander mittels Teilen des ersten (110, 110a) und des zweiten (112, 110b) Abschnittes aus Getter-Material elektrisch verbunden sind, welche die Verschweißungskontaktfläche (110a, 110b, 112, 114) bilden.

8. Struktur (100, 200) nach einem der vorhergehenden Ansprüche, die weiter eine Vorrichtung (104) aufweist, die im Hohlraum (106) angeordnet ist.

9. Struktur (100) nach einem der vorhergehenden Ansprüche, die weiter mindestens einen weiteren Abschnitt (118) aus mindestens einem Getter-Material aufweist, der in dem Hohlraum (106) angeordnet ist.

10. Struktur (100, 200, 300) nach einem der vorhergehenden Ansprüche, bei welcher der Abschnitt (110, 110a) aus Getter-Material gegen das erste Substrat (40, 102) oder das zweite Substrat (50, 108) mittels mindestens eines ersten Abschnittes aus mindestens einem Material angeordnet ist, das geeignet ist, die thermische Aktivierungstemperatur des Abschnittes (110, 110a) aus Getter-Material zu modifizieren, und/oder der zweite Abschnitt (110b, 112) aus Getter-Material respektive gegen das zweite Substrat (50, 108) oder das erste Substrat (40, 102) mittels mindestens eines zweiten Abschnittes aus mindestens einem Material angeordnet ist, das geeignet ist, die thermische Aktivierungstemperatur des zweiten Abschnittes (110b, 112) aus Getter-Material zu modifizieren.

11. Struktur (100, 200, 300) nach einem der vorhergehenden Ansprüche, bei welcher der Teil des zweiten Abschnittes (110b, 112) aus Getter-Material mit dem ersten Teil (114) des ersten Abschnittes (110, 110a) aus Getter-Material auf molekularer Ebene durch Verschweißen verbunden ist.

12. Verfahren zum Realisieren einer Struktur (100, 200, 300), das zumindest folgende Schritte beinhaltet:
- Realisieren mindestens eines ersten Abschnittes (110, 110a) aus mindestens einem Getter-Material gegen ein erstes Substrat (40, 102) oder ein zweites Substrat (50, 108),
- Realisieren mindestens eines zweiten Abschnittes (110b, 112) aus mindestens einem Getter-Material gegen das zweite Substrat (50, 108), wenn der erste Abschnitt (110, 110a) aus Getter-Material gegen das erste Substrat (40, 102) angeordnet ist, oder gegen das erste Substrat (40, 102), wenn der erste Abschnitt (110, 110a) aus Getter-Material gegen das zweite Substrat (50, 108) angeordnet ist,
- festes Verbinden des zweiten Substrates (50, 108) mit dem ersten Substrat (40, 102) durch Thermokompression eines ersten Teils (114) des ersten Abschnittes (110, 110a) aus Getter-Material gegen mindestens einen Teil des zweiten Abschnittes (110b, 112) aus Getter-Material, wobei mindestens ein Hohlraum (106, 302) erzeugt wird, der durch das erste Substrat (40, 102) und das zweite Substrat (50, 108) begrenzt ist, wobei ein zweiter Teil (116) des ersten Abschnittes (110, 110a) vom Getter-Material in dem Hohlraum (106) angeordnet ist.

13. Verfahren nach Anspruch 12, weiter beinhaltend, vor dem Schritt eines Realisierens des ersten Abschnittes (110) aus Getter-Material, einen Schritt eines Realisierens mindestens einer Vorrichtung (104) in dem und/oder gegen das erste Substrat (102), derart, dass diese, nach dem festen Verbinden des zweiten Substrates (108) mit dem ersten Substrat (102), in dem Hohlraum (106) angeordnet ist.

14. Verfahren nach einem der Ansprüche 12 oder 13, bei dem das Realisieren des ersten Abschnittes (110) aus Getter-Material mindestens einen Schritt beinhaltet, bei dem ein Ablagern in dünner Schicht des ersten Abschnittes (110) aus Getter-Material gegen das erste Substrat (102) oder das zweite Substrat (108) erfolgt.

15. Verfahren nach einem der Ansprüche 12 bis 14, bei dem das feste Verbinden des zweiten Substrates (50, 108) mit dem ersten Substrat (40, 102) beinhaltet, dass ein Verschweißen mittels molekularer Adhäsion des ersten Teils (114) des ersten Abschnittes (110, 110a) aus Getter-Material gegen den ersten Teil des zweiten Abschnittes (110b, 112) aus Getter-Material durchgeführt wird.

16. Verfahren nach Anspruch 15, das weiter, nach einem Realisieren des molekularen Verschweißens, einen Schritt einer Verfestigung mittels Wärmebehandlung der molekularer Verschweißung beinhaltet.

17. Verfahren nach einem der Ansprüche 12 bis 16, bei dem bei dem Schritt eines Realisierens des ersten (110) oder des zweiten (112) Abschnittes aus Getter-Material gegen das zweite Substrat (108) auch mindestens ein weiterer Abschnitt (118) aus Getter-Material gegen das zweite Substrat (108) erzeugt wird, derart, dass er in dem Hohlraum (106) angeordnet ist, und zwar nach dem festen Verbinden des zweiten Substrates (108) mit dem ersten Substrat (102).

18. Verfahren nach einem der Ansprüche 12 bis 17, weiter beinhaltend, vor dem Schritt eines festen Verbindens des zweiten Substrates (108) mit dem ersten Substrat (102) und nach den Schritten eines Realisierens des ersten (110) und des zweiten (112) Abschnittes aus Getter-Material, einen Schritt eines Oxidierens und/oder eines Nitrierens des ersten (110) und/oder des zweiten (112) Abschnittes aus Getter-Material, der unter trockener Disauerstoff- und/oder Distickstoff-Atmosphäre durchgeführt wird, wobei Schutzschichten auf Oxid- und/oder Nitrid-Basis des ersten (110) und/oder des zweiten (112) Abschnittes aus Getter-Material erzeugt werden, wobei die Schutzschichten während des Durchführens des Schrittes eines festen Verbindens beseitigt werden.

19. Verfahren nach Anspruch 18, bei dem der Schritt eines Oxidierens und/oder eines Nitrierens bei einem Druck zwischen ca. 1000 mbar und 10⁻² mbar und/oder einer Temperatur zwischen ca. 50 °C und 120 °C und/oder während einer Dauer zwischen ca. 1 min und 10 min durchgeführt wird.

20. Verfahren nach einem der Ansprüche 18 oder 19, weiter aufweisend, zwischen dem Schritt eines Oxidierens und/oder eines Nitrierens und dem Schritt eines festen Verbindens, das Durchführen eines Schrittes einer Wärmebehandlung des ersten (110) und/oder des zweiten (112) Abschnittes aus Getter-Material bei einer Temperatur, die um ca. 50 °C bis 150 °C tiefer bezogen auf die Aktivierungstemperatur des Abschnittes aus Getter-Material liegt, dessen Aktivierungstemperatur am niedrigsten ist, und unter Hochvakuum.

21. Verfahren nach einem der Ansprüche 12 bis 20, bei dem der erste (110, 110a) und der zweite Abschnitt (110b, 112) aus Getter-Material jeweils gegen mindestens einen ersten (80, 102) und einen zweiten (82, 204) elektrischen Kontakt realisiert werden, wobei der eine (80, 202) von dem ersten oder zweiten elektrischen Kontakt gegen das und/oder in dem ersten Substrat (40, 102) angeordnet ist und der andere (82, 204) von dem ersten und dem zweiten elektrischen Kontakt gegen das und/oder in dem zweiten Substrat (50, 108) angeordnet ist, und bei dem bei dem Schritt eines festen Verbindens der erste (80, 202) und der zweite (82, 204) elektrische Kontakt miteinander mittels des ersten (110, 110a) und des zweiten (110b, 112) Abschnittes aus Getter-Material elektrisch verbunden werden.

22. Verfahren nach einem der Ansprüche 12 bis 21, weiter aufweisend, vor dem Schritt eines Realisierens des ersten Abschnittes (110) aus Getter-Material, einen Schritt eines Realisierens mindestens eines ersten Abschnittes aus mindestens einem Material, das geeignet ist, die thermische Aktivierungstemperatur des ersten Abschnittes (110) aus Getter-Material zu modifizieren, gegen das erste Substrat (102) oder das zweite Substrat (108), wobei der erste Abschnitt (110) aus Getter-Material zumindest auf dem ersten Abschnitt des Materials realisiert wird, und/oder das Verfahren, vor dem Schritt eines Realisierens des zweiten Abschnittes (112) aus Getter-Material, weiter einen Schritt beinhaltet, bei dem mindestens ein zweiter Abschnitt aus mindestens einem Material, das fähig ist, die thermische Aktivierungstemperatur des zweiten Abschnittes (112) aus Getter-Material zu modifizieren, jeweils gegen das zweite Substrat (108) oder das erste Substrat (102) realisiert wird, wobei der zweite Abschnitt (112) aus Getter-Material zumindest auf dem zweiten Abschnitt des Materials realisiert wird.

23. Verfahren nach einem der Ansprüche, 12 bis 22, das weiter, nach dem festen Verbinden des zweiten Substrates (108) mit dem ersten Substrat (102), einen oder mehrere Schritte eines thermischen Aktivierens des oder der im Hohlraum (106) angeordneten Getter-Materialien (116, 118) beinhaltet.
